# EUROPEAN PATENT APPLICATION

(11) **EP 1 235 472 A1**
(43) Date of publication of application: **28.08.2002**
(21) Application number: 00970064.2
(22) Date of filing: 25.10.2000
(51) Int. Cl.: H05K 3/46

(54) **INSULATING AGENT FOR MULTILAYER PRINTED WIRING BOARD, INSULATING AGENT WITH METAL FOIL AND MULTILAYER PRINTED WIRING BOARD**

(30) Priority: 28.10.1999 JP 30750599; 28.10.1999 JP 30750699
(71) Applicant: Hitachi Chemical Company, Ltd., Tokyo 163-0449 (JP)
(72) Inventor: TAKAHASHI, Atsushi, Yuki-shi, Ibaraki 307-0001 (JP); ISHIDA, Yasuhisa, Yuki-shi, Ibaraki 307-0001 (JP); SASE, Shigeo, Shimodate-shi, Ibaraki 308-0064 (JP)
(74) Representative: HOFFMANN - EITLE
(86) International application number: JP0007463
(87) International publication number: WO01031985

(57) **Abstract**

An insulating material for a multi-layer printed wiring board containing a polyvinyl acetal resin and a thermosetting resin as essential components, said insulating material comprising a carboxylic acid-modified polyvinyl acetal resin as the polyvinyl acetal resin.

## Description

### BACKGROUND OF THE INVENTION

### (i) Field of the Invention

The present invention relates to an insulating material for a multi-layer printed wiring board, and an insulating material with a metal foil and a multi-layer printed wiring board in which the above insulating material for the multi-layer printed wiring board is used.

### (ii) Description of the Related Art

A printed wiring board is generally produced by forming a circuit on a copper-clad laminate obtained by laminating and hot-pressing a copper foil and a prepreg.

Furthermore, a multi-layer printed wiring board is generally produced by forming a circuit on the surface of a multi-layer copper-clad laminate incorporating an inner circuit, which is obtained by mutually hot-pressing the above printed wiring boards via a prepreg, or by hot-pressing the above printed wiring board and a copper foil via a prepreg.

In recent years, the reduction in size and weight, increase in performance and reduction in cost of electronic equipment have progressed, and also in the case of a printed wiring board, an increase in wiring density, a reduction in the thickness of substrates, an increase in the reliability of connections and a reduction in production costs have been sought. Above all, microwiring is required to increase wiring density. To achieve microwiring, the printed wiring board must have a flat surface and good dimensional stability. Moreover, the multi-layer printed wiring board must have a good drillability and good laser beam drillability, since it requires a fine through hole and an interstitial via hole (IVH) for electric connection between layers.

To obtain a printed wiring board having good surface flatness, it is necessary to heighten the flowability of a resin at the time of forming a multi-layer laminate. A low molecular-weight thermosetting resin such as a general-purpose epoxy resin is most suitably used for a printed wiring board, since this kind of resin shows high flowability before formed into the printed wiring board. Because of the high flowability, however, the resin does not possess so-called "film formability" to form an insulating material having the form of a sheet, without the resin being applied onto a reinforcing fiber such as a glass cloth.

Heretofore, a prepreg has been prepared by making a reinforcing base material such as a glass cloth impregnated with an insulating resin, and then being used in an insulating layer. However, in the case of a glass cloth that is generally used for a prepreg, a gap between glass fascicles (to be referred to as "yarn" hereinafter) becomes bigger as the glass cloth becomes thinner. Therefore, the thinner the glass cloth, the more susceptible it is to bending of the yarn or the phenomenon where the warp and weft thereof, which are supposed to intersect at right angles, do not intersect at right angles (to be referred to as "bowed filling" hereinafter). This bowed filling is liable to cause abnormal dimensional change or warp after the hot-pressing formation. Further, since the gap between yarns becomes bigger as the glass cloth becomes thinner, the rigidity of an interlayer insulating layer lowers as the volume fraction of fibers of the prepreg lowers, whereby the board is liable to warp severely in the step of, for example, mounting components thereon after the formation of an outer circuit.

Further, when the thickness of the prepreg is reduced by reducing the amount of the resin in order to reduce the size of the wiring board, the padability of the resin on the protrusions and recesses of the inner circuit lowers, thereby generating voids. On the other hand, when the glass cloth is made thinner, the strength of the cloth itself is reduced. By reducing the strength, the glass cloth becomes liable to break in the step of impregnating the glass cloth with the resin, thereby making it difficult to produce the prepreg.

Further, when a multi-layer printed wiring board using a glass cloth is drilled, a small-diameter drill is liable to wobble and break due to the uneven distribution of glass cloth. Furthermore, due to the presence of the glass cloth in the prepreg, drillability with a laser is not satisfactory: the projections and recesses of the inner circuit are liable to come to the surface and, therefore, the surface smoothness is poor.

Meanwhile, an adhesive film (Japanese Patent Application Laid-Open Nos. 200216/1994 and 242465/1994) and an adhesive film with a copper foil (Japanese Patent Application Laid-Open No. 196862/1994) which are prepregs using no glass cloth can be made thinner and have excellent small-diameter drillability and laser beam drillability. However, use of the conventionally used epoxy adhesive film or polyimide film for these films increases costs. To keep the costs low, a mixture of a polyvinyl acetal resin and a thermosetting resin can be used as an insulating material having the form of a sheet (Japanese Patent Publication No. 58393/1988 and Japanese Patent Application Laid-Open No. 134425/1996). However, since the thermosetting resin to be used has low reactivity with the polyvinyl acetal resin, uneven coloration occurs in the cured resin. Therefore, such properties as adhesive property and heat resistance may be varied. Further, when the resin is used as a insulating material, the insulating material has a defect in that it has inferior chemical resistance, as exemplified by the exfoliation of the surface that occurs in the step of removing a smear with permanganic acid.

### SUMMARY OF THE INVENTION

It is an object of the present invention to provide a low-cost insulating material for a multi-layer printed wiring board, which shows good chemical resistance after the formation of a multi-layer laminate when used as an insulating material for a multi-layer printed wiring board, an insulating material with a metal foil, and a multi-layer printed wiring board.

According to a first aspect of the invention, there is provided an insulating material for a multi-layer printed wiring board containing a polyvinyl acetal resin and a thermosetting resin as essential components, the insulating material comprising a carboxylic acid-modified polyvinyl acetal resin as the polyvinyl acetal resin.

According to another aspect of the invention, there is provided an insulating material for a multi-layer printed wiring board which comprises a polyvinyl acetal resin, a crosslinking agent for the polyvinyl acetal resin, and a thermosetting resin.

According to a further aspect of the invention, there is provided the crosslinking agent for the polyvinyl acetal resin is a melamine resin.

According to a further aspect of the invention, there is provided the polyvinyl acetal resin contains a carboxylic acid-modified polyvinyl acetal.

According to a further aspect of the invention, there is provided a total amount of the polyvinyl acetal resin and the crosslinking agent is not more than 50% by weight of all the resin portions.

According to a further aspect of the invention, there is provided the proportion of the moieties acetalized by acetaldehyde in the polyvinyl acetal resin is 10 to 100% by weight of all the acetalized moieties.

According to a further aspect of the invention, there is provided the thermosetting resin comprises an epoxy resin.

According to a further aspect of the invention, there is provided an insulating material with a metal foil, which is obtained by laminating, on a metal foil, the insulating material for the multi-layer printed wiring board in a semi-cured state.

According to a further aspect of the invention, there is provided a multi-layer printed wiring board, wherein an insulating resin layer that supports an outer circuit comprises the insulating material for the multi-layer printed wiring board, and an inner circuit formed on an inner circuit board is electrically connected to the outer circuit.

According to a further aspect of the invention, there is provided a multi-layer printed wiring board, wherein an outer circuit and an insulating resin layer that supports the outer circuit are formed from the insulating material with the metal foil, and an inner circuit formed on an inner circuit board is electrically connected to the outer circuit.

The insulating material for a multi-layer printed wiring board of the present invention exhibits good heat resistance and good adhesive property and has no uneven coloration after the formation of a multi-layer laminate and no exfoliation of the resin layer when immersed in permanganic acid or the like. Further, when the insulating material for a multi-layer printed wiring board of the present invention is used, there can be produced a low-cost insulating material with a metal foil having the good properties described above, and a multi-layer printed wiring board using the insulating material with a metal foil.

The present disclosure relates to subject matter contained in Japanese Patent Application No.HEI 11-307505, filed on October 28, 1999, and No.HEI 11-307506,filed on October 28, 1999, the disclosure of which expressly incorporated herein by reference in its entirety.

### BREIF DESCRIPTION OF THE DRAWING

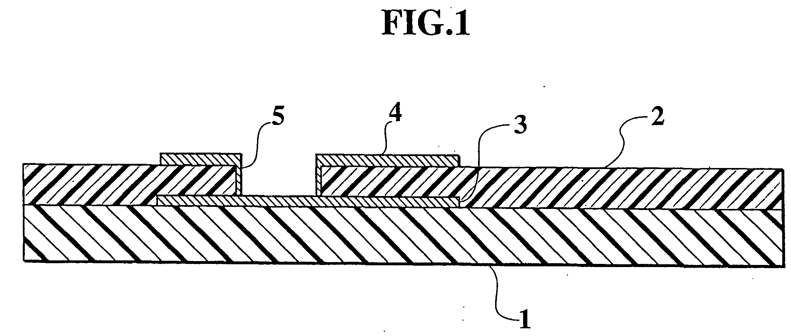

Fig.1 is a sectional view of one exemplary circuit in which an inner circuit is conducted to an outer circuit.

### DETAILED DESCRIPTION OF THE PREFERRED EMBODIMENT

The insulating material for a multi-layer printed wiring board of the present invention will be described in detail hereinafter.

### (Polyvinyl acetal resin)

The insulating material of the present invention contains a polyvinyl acetal resin and a thermosetting resin as essential components. The polyvinyl acetal resin can be obtained by reacting a polyvinyl alcohol with an aldehyde. For example, a polyvinyl acetal can be obtained when acetaldehyde is used as the aldehyde, and a polyvinyl butyral can be obtained when butyraldehyde is used as the aldehyde.

Although the degree of polymerization and degree of acetalization of the polyvinyl acetal resin in the present invention are not particularly limited, the polyvinyl acetal resin is desirably one which has an average degree of polymerization of 500 to 3,000 and a degree of acetalization of 60 to 100 mol%. When the average degree of polymerization is lower than 500, the heat resistance of the adhesive is not sufficient, while the average degree of polymerization is higher than 3,000, the viscosity of the adhesive becomes too high, thereby making it difficult to apply the adhesive to the metal foil. The degree of acetalization is not particularly limited as long as it falls within the above range. However, when it is less than 60 mol%, the resin lacks flexibility and adhesive strength.

Preferably, the proportion of the moieties acetalized by acetaldehyde in the polyvinyl acetal resin is 10 to 100 mol% of all the acetalized moieties. More preferably, the polyvinyl acetal resin is a polyvinyl acetal resin in which the proportion of the moieties acetalized by acetaldehyde is at least 50mol% of all the acetalized moieties in the resin.

The number average degree of polymerization of the polyvinyl acetal resin can be determined, for example, by the number average molecular weight (measured by using the calibration curve of standard polystyrene by gel permeation chromatography) of polyvinyl acetate used as raw material thereof. As commercial products thereof, ESLEC KS-3Z, ESLEC KS-5, ESLEC KS-5Z and ESLEC KS-8 (products of SEKISUI CHEMICAL CO., LTD., trade names) and DENKA butyral 5000A and DENKA butyral 6000C (products of DENKI KAGAKU KOGYO K.K.) can be used.

### (Carboxylic acid-modified polyvinyl acetal resin)

In the present invention, a carboxylic acid-modified polyvinyl acetal resin is preferably contained as the polyvinyl acetal resin. The "carboxylic acid-modified polyvinyl acetal resin" is a general term for a polymer obtained by condensation polymerizing an aldehyde with a carboxylic acid-modified polyvinyl alcohol obtained by copolymerizing a polyvinyl alcohol with an unsaturated carboxylic acid having at least two carboxyl groups such as itaconic acid. The carboxylic acid-modified polyvinyl acetal resin has an acetal bond in the molecule. For example, a carboxylic acid-modified polyvinyl acetal can be obtained when acetaldehyde is used as the aldehyde, and a carboxylic acid-modified polyvinyl butyral can be obtained when butyraldehyde is used as the aldehyde.

Although the degree of polymerization and degree of acetalization of the carboxylic acid-modified polyvinyl acetal resin in the present invention are not particularly limited, the carboxylic acid-modified polyvinyl acetal resin is desirably one which has an average degree of polymerization of 500 to 3,000 and a degree of acetalization of 60 to 100 mol%. When the average degree of polymerization is lower than 500, the heat resistance of the adhesive is not sufficient, while the average degree of polymerization is higher than 3,000, the viscosity of the adhesive becomes too high, thereby making it difficult to apply the adhesive to the metal foil. The degree of acetalization is not particularly limited as long as it falls within the above range. However, when it is less than 60 mol%, the resin lacks flexibility and adhesive strength.

The number average degree of polymerization of the carboxylic acid-modified polyvinyl acetal resin can be determined, for example, by the number average molecular weight (measured by using the calibration curve of standard polystyrene by gel permeation chromatography) of the copolymer of vinyl acetate and the unsaturated carboxylic acid having at least two carboxyl groups used as raw materials thereof. Illustrative examples of commercial products of the carboxylic acid-modified polyvinyl acetal resin include ESLEC KS-23 and ESLEC HS-1 (products of SEKISUI CHEMICAL CO., LTD., trade names).

It is preferable from the viewpoints of uniform thickness and heat resistance to use the carboxylic acid-modified polyvinyl acetal resin in an amount of 5 to 50% by weight based on the total weight of the resin portions (including a curing agent and an accelerator) of the insulating material for a multi-layer printed wiring board of the present invention. When the amount of the carboxylic acid-modified polyvinyl acetal resin is too small, an insulating layer having a uniform thickness cannot be easily obtained. When it is too large, on the other hand, heat resistance or the like is liable to be lowered.

When a polyvinyl acetal that is not modified by an unsaturated carboxylic acid having at least two carboxylic groups is used, the resin of the insulating layer after the formation of a multi-layer laminate may separate into the acetal resin and the epoxy resin, because of low reactivity. In such a case, the insulting layer lacks uniformity and has uneven coloration. Further, the surface of the resin of the insulating layer may be exfoliated in the step of removing a smear with permanganic acid or the like.

The carboxylic acid-modified polyvinyl acetal resin may be mixed and used with a polyvinyl acetal resin such as polyvinyl butyral which is not modified by an unsaturated carboxylic acid having at least two carboxylic groups.

### (Crosslinking agent for polyvinyl acetal resin)

In the present invention, a crosslinking agent for a polyvinyl acetal can be mixed into the insulating material. Particularly when the polyvinyl acetal is not acid-modified, the crosslinking agent is an essential component.

Illustrative examples of the crosslinking agent for a polyvinyl butyral resin include a resol-type phenol resin, a melamine resin, a poly-(or di-)isocyanate compound, glyoxasol and derivatives thereof. Particularly, from the viewpoint of adhesive property, heat resistance, chemical resistance, insulating property, reactivity and the like, a methylolized melamine resin and a methylolized melamine resin alkoxylated by an alcohol are preferably used.

The crosslinking agent is preferably used in an amount of 1 to 100 parts by weight based on 100 parts by weight of the polyvinyl butyral resin. When the amount of the crosslinking agent is less than 1 part by weight, the crosslinking of the polyvinyl acetal resin is insufficient, whereby chemical resistance or the like is liable to lower. When the amount of the crosslinking agent is more than 100 parts by weight, the padability of the insulating material on the inner layer at the time of forming a multi-layer laminate and heat resistance thereof may be lowered. When the crosslinking agent is used, the crosslinking agent is mixed, particularly preferably from the viewpoints of uniform thickness and heat resistance, in such an amount that the total amount of the polyvinyl acetal resin and the crosslinking agent is 50% or less, more preferably, 5 to 50% by weight based on the total weight of the resin portions (including a curing agent and an accelerator) of the insulating material for a multi-layer printed wiring board in the present invention.

### (Thermosetting resin)

In addition to the polyvinyl acetal resin and the crosslinking agent, there may be used an epoxy resin, a polyimide resin, a bismaleimide triazine resin, a benzooxazine resin, a photosensitive resin having an unsaturated double bond such as epoxy acrylate or a resin which undergoes crosslinking by causing a reaction by the application of heat or light, as the thermosetting resin used in the present invention. It is preferable from the viewpoints of adhesive property, heat resistance, chemical resistance and the like that at least the epoxy resin out of the above thermosetting resins be contained.

### (Epoxy resin)

The epoxy resin used in the present invention may be any compound having at least two epoxy groups in the molecule. Preferable examples of the epoxy resin include a bisphenol A-type epoxy resin, a bisphenol F-type epoxy resin, a bisphenol S-type epoxy resin, a phenol-novolac-type epoxy resin, a cresol-novolac-type epoxy resin, a bisphenol A-novolac-type epoxy resin, a salicylaldehyde-novolac-type epoxy resin, a bisphenol F-novolac-type epoxy resin, a glycidyl ester-type epoxy resin, a glycidyl amine-type epoxy resin, a hydantoin-type epoxy resin, an isocyanate-type epoxy resin, an alicyclic epoxy resin, and halides, hydrides and mixtures of these resins. The bisphenol A-novolac-type epoxy resin is particularly preferable because it is excellent in heat resistance.

### (Curing agent)

A curing agent may be used for accelerating the curing of the thermosetting resin. Particularly, the curing agent for the epoxy resin is not particularly limited as long as it is one that is generally used for curing an epoxy resin. Illustrative examples of the curing agent include dicyandiamide, bisphenol A, a polyvinyl phenol, a phenol-novolac resin, a bisphenol A-novolac resin, and halides and hydrides of these phenol resins. Of these, the bisphenol A-novolac-type resin is preferable because it has excellent heat resistance.

The proportion of the curing agent to the epoxy resin may be one that has been conventionally used, and is preferably 2 to 100 parts by weight based on 100 parts by weight of the epoxy resin. The proportion is particularly preferably 2 to 5 parts by weight when dicyandiamide is used as the curing agent. The proportion is preferably 30 to 80 parts by weight when the curing agent is not dicyandiamide.

In the present invention, the total proportion of the above epoxy resin and curing agent therefor is 50 to 90% by weight based on the total weight of all the resins. When the proportion is lower than 50% by weight, the formability at the time of producing a multi-layer printed wiring board is liable to be lowered. When the proportion is higher than 90% by weight, handling properties may lower due to the occurrence of exfoliation of the resin from, for example, the cut portion of an insulating material with a metal foil.

### (Accelerator)

An accelerator may be used for further accelerating the curing reaction. Illustrative examples of the accelerator when the resin is an epoxy rein include an imidazole compound, an organophosphorus compound, a tertiary amine and a quaternary ammonium salt. The proportion of the accelerator to the epoxy resin may be one that has been conventionally used, and is preferably 0.01 to 20 parts by weight, more preferably 0.1 to 1.0 parts by weight, based on 100 parts by weight of the resin.

### (Diluent)

The resin portions (including a crosslinking agent, a curing agent and an accelerator) of the present invention can be diluted with a solvent in order to be used as a resin varnish. Illustrative examples of the solvent include acetone, methyl ethyl ketone, toluene, xylene, methyl isobutyl ketone, ethyl acetate, ethylene glycol monomethyl ether, methanol, ethanol, N,N-dimethylformamide and N,N-dimethylacetoamide. The proportion of the diluent to the resin portions may be one that has been conventionally used, and is preferably 1 to 200 parts by weight, more preferably 30 to 100 parts by weight, based on 100 parts by weight of the resin.

### (Other compounding agents)

Further, in the present invention, a coupling agent, a filler and the like may be compounded in the resin as required, in addition to the above components.

An insulating material with a metal foil can be obtained by applying the thus-obtained insulating material in the form of a varnish to a metal foil such as a copper foil and drying the varnish to a semi-cured state. The metal foil preferably has a roughened surface for increasing the adhesive strength of the resin.

A multi-layer metal-clad laminate incorporating an inner circuit board can be fabricated by applying an insulating material to an inner circuit board, laminating a metal foil thereon and pressurizing the resulting board under heating, or by laminating an insulating material with a metal foil on an inner circuit board such that the insulating material faces the board and pressuring the resulting board under heating.

By conducting the step of forming an outer circuit and the step of conducting the inner circuit to the outer circuit on the thus-obtained multi-layer metal-clad laminate in accordance with a common method, a multi-layer printed wiring board in which the inner circuit formed on the inner circuit board is electrically connected to the outer circuit can be fabricated.

One embodiment of the thus-fabricated printed wiring board is shown in Fig. 1. In Fig. 1, the insulating material (2) of the present invention is formed on an insulating layer (1) formed on an inner circuit (3), an outer circuit (4) is formed on the insulating material (2), and the inner circuit is connected to the outer circuit via metal plating (5) by making a conducting hole at a spot where the two circuits are to be connected to each other.

Examples and Comparative Examples of the present invention will be described hereinafter.

### (Example 1)

There was prepared a composition comprising 100 parts by weight of a bisphenol A-type epoxy resin (epoxy equivalent: 190, molecular weight: 380), 10 parts by weight of dicyandiamide, 0.4 parts by weight of 2-ethyl-4-methylimidazole, and 20 parts by weight of KS-23 (product of SEKISUI CHEMICAL CO., LTD., trade name, degree of polymerization: 1,700, degree of acetalization: 71 mol%, carboxylic acid and itaconic acid: 1.2 mol% each) as carboxylic acid-modified polyvinyl acetal. Further, methyl ethyl ketone, methanol and toluene were added to this composition to prepare a 40-wt% varnish.

This varnish was applied to the roughened surface of a single-roughened-surface copper foil having a thickness of 18 µm in such an amount that the insulating material should have a thickness of 50 µm when dried. The insulating material was dried at 150°C for 3 minutes to obtain an insulating material with a copper foil in a semi-cured state.

This insulating material with a copper foil was laminated on both sides of an inner circuit board obtained by forming a circuit on a double copper-clad laminate having a thickness of 0.2 mm and a copper foil thickness of 35 µm, in such a manner that the insulating material faces the inner circuit board. The resulting circuit board was hot-pressed under the conditions of 170°C, 90 minutes and 2 MPa to form into a multi-layer copper-clad laminate incorporating an inner circuit.

To examine formability, the outer copper foil of the copper-clad laminate incorporating an inner circuit was removed by etching, and the resin uniformity of the insulating material was observed visually. As a result, the resin uniformity of the insulating material was found to be good.

Further, to examine heat resistance, the copper-clad laminate incorporating an inner circuit was immersed in a bath of molten solder at 280°C, and the state of adhesion of the insulating material was then observed visually. As a result, heat resistance thereof was found to be good because no blisters and the like were observed on the copper-clad laminate even when it was immersed for over 60 seconds.

Next, to examine the adhesive properties, the strength required to strip off the 18-µm-thick 3-mm-wide outer copper foil of the copper-clad laminate incorporating an inner circuit was measured with TENSILON (manufactured by ADVANTEST Corp.) . The copper foil was stripped at a speed of 50 mm/min in accordance with JIS C-6481. As a result, it was good as 1.5 kN/m.

Then, a multi-layer printed wiring board was fabricated by forming a through hole and an outer circuit in accordance with a common method using the outer copper foil of the copper-clad laminate incorporating an inner circuit. Thirty-eight grams of sodium hydroxide and 60 g of potassium permanganate were dissolved in 1 liter of water. To examine chemical resistance, the above wiring board was immersed in an alkaline aqueous solution of permanganic acid maintained at 70°C for 10 minutes. As a result, no exfoliation of the insulating layer or the like was observed.

### (Example 2)

An insulating material with a copper foil was fabricated and a multi-layer copper-clad laminate incorporating an inner circuit was obtained in the same manner as in Example 1 except that the amount of the carboxylic acid-modified polyvinyl acetal was changed from 20 parts by weight to 40 parts by weight.

Then, when formability was examined in the same manner as in Example 1, the resin uniformity of the insulating material was found to be good. As for heat resistance, it was found to be good because no blisters and the like were observed on the copper-clad laminate even when it was immersed in a bath of molten solder for over 60 seconds. As for the adhesive properties, they were found to be good as 1.5 kN/m.

Next, a multi-layer printed wiring board was fabricated in the same manner as in Example 1 by using the outer copper foil of the copper-clad laminate incorporating an inner circuit, and chemical resistance was examined. As a result, no exfoliation of the insulating layer or the like was observed.

### (Example 3)

To a composition comprising 100 parts by weight of BX-5Z (product of SEKISUI CHEMICAL CO., LTD., trade name, degree of polymerization: 2,000, degree of acetalization: 70 mol%) as polyvinyl butyral, 20 parts by weight of M220 (Hitachi Chemical Co., Ltd., trade name) as a butanol-modified methylolized melamine resin, 500 parts by weight of a bisphenol A-type epoxy resin (epoxy equivalent: 190, molecular weight: 380), 50 parts by weight of dicyandiamide, and 2 parts by weight of 2-ethyl-4-methylimidazole, methyl ethyl ketone, methanol and toluene were added to prepare a 40-wt% varnish.

Using this varnish, an insulating material with a copper foil in a semi-cured state was fabricated and a multi-layer copper-clad laminate incorporating an inner circuit was obtained in the same manner as in Example 1.

When the formability of the insulating material was examined in the same manner as in Example 1, the resin uniformity of the insulating material was found to be good. As for heat resistance, it was found to be good because no blisters and the like were observed on the copper-clad laminate even when it was immersed in a bath of molten solder for over 60 seconds. As for the adhesive properties, they were found to be good as 1.5 kN/m.

Next, a multi-layer printed wiring board was fabricated in the same manner as in Example 1 by using the outer copper foil of the copper-clad laminate incorporating an inner circuit, and chemical resistance was examined. As a result, no exfoliation of the insulating layer or the like was observed.

### (Example 4)

An insulating material with a copper foil was fabricated and a multi-layer copper-clad laminate incorporating an inner circuit was obtained in the same manner as in Example 3 except that the amount of the polyvinyl butyral was changed from 100 parts by weight to 200 parts by weight.

Then, when formability was examined in the same manner as in Example 3, the resin uniformity of the insulating material was found to be good. As for heat resistance, it was found to be good because no blisters and the like were observed on the copper-clad laminate even when it was immersed in a bath of molten solder for over 60 seconds. As for the adhesive property, they were found to be good as 1.5 kN/m.

Next, a multi-layer printed wiring board was fabricated in the same manner as in Example 3 by using the outer copper foil of the copper-clad laminate incorporating an inner circuit, and chemical resistance was examined. As a result, no exfoliation of the insulating layer or the like was observed.

### (Example 5)

To a composition comprising 100 parts by weight of a bisphenol A-novolac-type epoxy resin (epoxy equivalent: 208, molecular weight: 1,250), 40 parts by weight of a bisphenol A-novolac resin (hydroxy group equivalent: 108, molecular weight: 700), 40 parts by weight of bisphenol A tetrabromide, 0.4 parts by weight of 2-ethyl-4-methylimidazole, and 20-parts by-weight of carboxylic acid-modified polyvinyl acetal (degree of polymerization: 1,700, degree of acetalization: 71 mol%, carboxylic acid and itaconic acid: 1.2 mol% each), methyl ethyl ketone, methanol and toluene were added to prepare a 40-wt% varnish.

Using this varnish, an insulating material with a copper foil in a semi-cured state was obtained in the same manner as in Example 1.

Then, using this insulating material with a copper foil, a multi-layer copper-clad laminate incorporating an inner circuit was fabricated in the same manner as in Example 1.

When formability was examined in the same manner as in Example 1, the resin uniformity of the insulating material was found to be good. As for heat resistance, it was found to be good because no blisters and the like were observed on the copper-clad laminate even when it was immersed in a bath of molten solder for over 60 seconds. As for the adhesive properties, they were found to be good as 1.5 kN/m.

Next, a multi-layer printed wiring board was fabricated in the same manner as in Example 1 by using the outer copper foil of the copper-clad laminate incorporating an inner circuit, and chemical resistance was examined. As a result, no exfoliation of the insulating layer or the like was observed.

### (Comparative Example 1)

An insulating material with a copper foil was fabricated and a multi-layer copper-clad laminate incorporating an inner circuit was obtained in the same manner as in Example 1 except for a polyvinyl butyral with high degree of polymerization of 2,000 which was not modified by carboxylic acid.

Next, when formability was examined in the same manner as in Example 1, uneven coloration in the form of strips occurred at the edges of the inner circuit board. As for heat resistance to soldering, it was found to be good because no blisters and the like were observed on the copper-clad laminate even when it was immersed in a bath of molten solder over 60 seconds. As for the adhesive property, they were found to be good as 1.5 kN/m.

Next, a multi-layer printed wiring board was fabricated in the same manner as in Example 1 by using the outer copper foil of the copper-clad laminate incorporating an inner circuit, and chemical resistance was examined. As a result, the insulating layer was exfoliated.

### (Comparative Example 2)

To a composition comprising 100 parts by weight of BX-5Z (product of SEKISUI CHEMICAL CO., LTD., trade name, degree of polymerization: 2,000, degree of acetalization: 70 mol%) as polyvinyl butyral, 500 parts by weight of a bisphenol A-type epoxy resin (epoxy equivalent: 190, molecular weight: 380), 50 parts by weight of dicyandiamide, and 2 parts by weight of 2-ethyl-4-methylimidazole, methyl ethyl ketone, methanol and toluene were added to prepare a 40-wt% varnish.

Using this varnish, an insulating material with a copper foil in a semi-cured state was obtained in the same manner as in Example 1.

Then, using this insulating material with a copper foil, a multi-layer copper-clad laminate incorporating an inner circuit was obtained in the same manner as in Example 1.

When formability was examined in the same manner as in Example 1, the occurrence of uneven coloration was observed in the resin. As for heat resistance, the occurrence of blisters was observed on the copper-clad laminate after it was immersed in a bath of molten solder for 20 seconds. As for the adhesive properties, they were found to be good as 1.5 kN/m.

Next, a multi-layer printed wiring board was fabricated in the same manner as in Example 1 by using the outer copper foil of the copper-clad laminate incorporating an inner circuit, and chemical resistance was examined. As a result, no exfoliation of the insulating layer or the like was observed.

### INDUSTRIAL APPLICABILITY

As described above, the insulating material for a multi-layer printed wiring board according to the present invention is excellent in the formability, heat resistance, adhesive properties and chemical resistance after the formation of a multi-layer laminate, and an insulating material with a metal foil and a multi-layer printed wiring board which use the above insulating material are also useful.

It will be further understood by those skilled in the art that the foregoing description is a preferred embodiment of the invention and that various changes and modifications may be made in the invention without departing from the sprit and scope thereof.

## Claims

1. An insulating material for a multi-layer printed wiring board containing a polyvinyl acetal resin and a thermosetting resin as essential components, said insulating material comprising a carboxylic acid-modified polyvinyl acetal resin as the polyvinyl acetal resin.

2. An insulating material for a multi-layer printed wiring board which comprises a polyvinyl acetal resin, a crosslinking agent for the polyvinyl acetal resin, and a thermosetting resin.

3. The insulating material for the multi-layer printed wiring board according to claim 2, wherein the crosslinking agent for the polyvinyl acetal resin includes a melamine resin.

4. The insulating material for the multi-layer printed wiring board according to claim 2, wherein the polyvinyl acetal resin contains a carboxylic acid-modified polyvinyl acetal.

5. The insulating material for the multi-layer printed wiring board according to claim 2, wherein the total amount of the polyvinyl acetal resin and the crosslinking agent are not more than 50 % by weight of all the resin portions.

6. The insulating material for a multi-layer printed wiring board according to claim 1, wherein the proportion of the moieties acetalized by acetaldehyde in the polyvinyl acetal resin is 10 to 100 mol% of all the acetalized moieties.

7. The insulating material for a multi-layer printed wiring board according to claim 2, wherein the proportion of the moieties acetalized by. acetaldehyde in the polyvinyl acetal resin is 10 to 100 mol% of all the acetalized moieties

8. The insulating material for the multi-layer printed wiring board according to claim 1, wherein the thermosetting resin comprises an epoxy resin.

9. The insulating material for the multi-layer printed wiring board according to claim 2, wherein the thermosetting resin comprises an epoxy resin.

10. An insulating material with a metal foil, which is obtained by laminating, on a metal foil, the insulating material for the multi-layer printed wiring board according to claim 1 in a semi-cured state.

11. An insulating material with a metal foil, which is obtained by laminating, on a metal foil, the insulating material for the multi-layer printed wiring board according to claim 2 in a semi-cured state.

12. A multi-layer printed wiring board, wherein an insulating resin layer that supports an outer circuit comprises the insulating material for the multi-layer printed wiring board according to claim 1, and an inner circuit formed on an inner circuit board is electrically connected to the outer circuit.

13. A multi-layer printed wiring board, wherein an insulating resin layer that supports an outer circuit comprises the insulating material for the multi-layer printed wiring board according to claim 2, and an inner circuit formed on an inner circuit board is electrically connected to the outer circuit.

14. A multi-layer printed wiring board, wherein an outer circuit and an insulating resin layer that supports the outer circuit are formed from the insulating material with the metal foil according to claim 10, and an inner circuit formed on an inner circuit board is electrically connected to the outer circuit.
